# EUROPEAN PATENT APPLICATION

(11) **EP 0 776 725 A1**
(43) Date of publication of application: **04.06.1997**
(21) Application number: 95919645.2
(22) Date of filing: 26.05.1995
(51) Int. Cl.: B23K 26/00, B23K 26/02

(54) **METHOD OF MARKING WORKS**

(30) Priority: 17.08.1994 JP 193264/94
(71) Applicant: KOMATSU LTD., Minato-ku Tokyo 107 (JP)
(72) Inventor: MISUGI, Koji Kabushiki Kaisha Komatsu Seisakusho, Kanagawa 254 (JP)
(74) Representative: Fiener, Josef
(86) International application number: JP9501016
(87) International publication number: WO9605017

(57) **Abstract**

A method of marking works according to the invention comprises alternately performing such operations on at least two lines of a plurality of parallel lines, that a lead frame (16-1) in a line B is conveyed to a marking area (26) to be kept on stand-by there while marking works on a lead frame (15-1) in a line A, and upon completion of marking the lead frame (15-1) in the line A, works on the lead frame (16-1) in the line B are subjected to marking, and in the meantime a subsequent lead frame (15-2) in the line A is conveyed to the marking area (26) to be kept on stand-by there. Further, laser light is outputted in a substantially continuous manner even when switching (conveyance) is effected from works to works, whereby loss in working time during the conveyance of works is eliminated and a handling time is shortened as much as possible.

## Description

### TECHNICAL FIELD

This invention relates to a marking device for marking prescribed printing patterns onto works, and in particular, it relates to a method of marking works whereby marking can be conducted at high speed.

### BACKGROUND ART

Marking devices are devices which irradiate laser light onto a mask wherein a printing pattern is formed, such that the laser light passing through the mask falls onto works which are to be processed and the aforementioned printing pattern is marked onto the surfaces thereof.

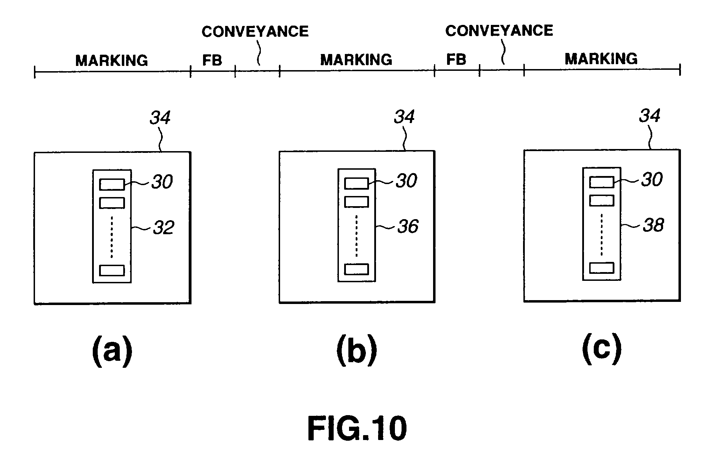

A procedure for marking works by means of a conventional marking device is described with reference to Fig.10. This diagram shows a plan view of an arrangement of works, and the horizontal axis indicates the details of corresponding operations. The transmissivity feedback (FB) processing implemented between marking and conveyance is described later.

Firstly, as shown in (a), a lead frame 32, whereon a plurality of works 30 is mounted, is conveyed by means of a conveyer (omitted from drawing) to a region where marking is possible (hereafter, marking area) 34, and each of the works 30 is subjected to marking by means of laser light which is caused to scan via an optical system (omitted from drawing).

When marking of the works is completed, the lead frame 32 is conveyed from the marking area 34, and as shown in (b), a subsequent lead frame 36 is conveyed to the marking area 34. Thereupon, the works 30 on the newly conveyed lead frame 36 are subjected to marking.

When marking of the works is completed, the lead frame 36 is conveyed from the marking area 34, and as shown in (c), a subsequent lead frame 38 is conveyed to the marking area 34. Thereupon, the works 30 on the newly conveyed lead frame 38 are subjected to marking.

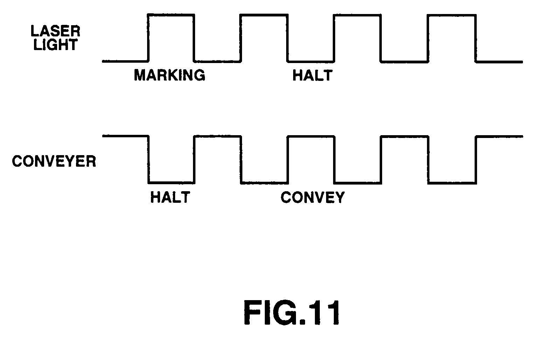

Fig.11 shows a time-chart representation of the marking operation described above. During marking by the laser light, conveyance of the works by the conveyer is halted, and when marking is completed, the output of laser light is halted whilst the subsequent works are conveyed by the conveyer.

In marking operations using a marking device, it is desirable to shorten the handling time (the overall time required for marking). However, in a conventional marking method as described above, during switching (conveyance) from marked works to the subsequent works, the marking device is halted and does not carry out marking, and therefore the working time during which the works are conveyed is wasted. In other words, in marking operations based on conventional techniques, operational efficiency has been poor, and it has been difficult to shorten the handling time.

### DISCLOSURE OF THE INVENTION

It is an object of this invention to provide a method of marking works, whereby waste in working time is eliminated and handling time can be shortened as far as possible.

Furthermore, it is an object of this invention to provide a method of marking works whereby irregularity in marking quality arising when the handling time is shortened can be reduced as much as possible.

In the method of marking works relating to this invention, works are arranged on a plurality of parallel lines, the plurality of lines is conveyed and halted independently, and whilst works on a line halted in the marking area are being marked, works on at least one of the remaining lines are conveyed to the marking area. By this means, it is possible to output laser light in a virtually continuous manner, even during switching (conveyance) from works to works, thereby making it possible to eliminate waste in working time during conveyance of works, and to shorten the handling time as much as possible.

Furthermore, in the method of marking works relating to the present invention, if the mask is a liquid crystal mask, the transmissivity of this liquid crystal mask is controlled at a frequency corresponding to the number of work marking cycles. Accordingly, by specifying the temperature region of the liquid crystal mask according to the number of marking cycles, it is possible to control the transmissivity of the mask at a timing corresponding to this temperature region, and hence the transmissivity of the mask can be maintained at a virtually constant level, without impairing the merits of continuously conveying the works.

Moreover, in the method of marking works relating to the present invention, in cases wherein the mask is a liquid crystal mask, the transmissivity of this liquid crystal mask is controlled at a frequency corresponding to temperature measurements at the perimeter of the liquid crystal mask. Accordingly, by specifying the temperature region of the liquid crystal mask by direct measurement of the temperature at the perimeter of the liquid crystal mask, it is possible to control the transmissivity at a timing corresponding to this temperature region, and hence the transmissivity of the mask can be maintained at a virtually constant level, without impairing the merits of continuously conveying the works.

### BRIEF DESCRIPTION OF THE DRAWINGS

Fig.1 is a diagram showing an arrangement of works when marking is carried out;
Fig.2 is an approximate composite diagram of a marking device to which the method of marking works relating to this invention is applied;
Fig.3 is a diagram showing the manner in which laser light is scanned over a display surface;
Fig.4 is a schematic diagram representing a procedure when works are marked alternately;
Fig.5 is a time-chart of an alternate marking operation;
Figs. 6(a), 6(b) and 6(c) are diagrams showing the positional relationships of works in a marking area;
Fig.7 is a diagram showing the relationship between temperature and transmissivity in liquid crystals, for different drive voltages;
Fig.8 is a flow-chart showing processing steps in a controller when transmissivity is controlled according to the number of marking cycles;
Fig.9 is a flow-chart showing processing steps in a controller when transmissivity is controlled according to the temperature at the perimeter of a liquid crystal mask;
Fig.10 is a diagram showing a procedure for marking works by means of a conventional marking device; and
Fig.11 is a time-chart of a conventional marking operation.

### BEST MODE FOR CARRYING OUT THE INVENTION

Below, one embodiment of a method of marking works relating to this invention is described.

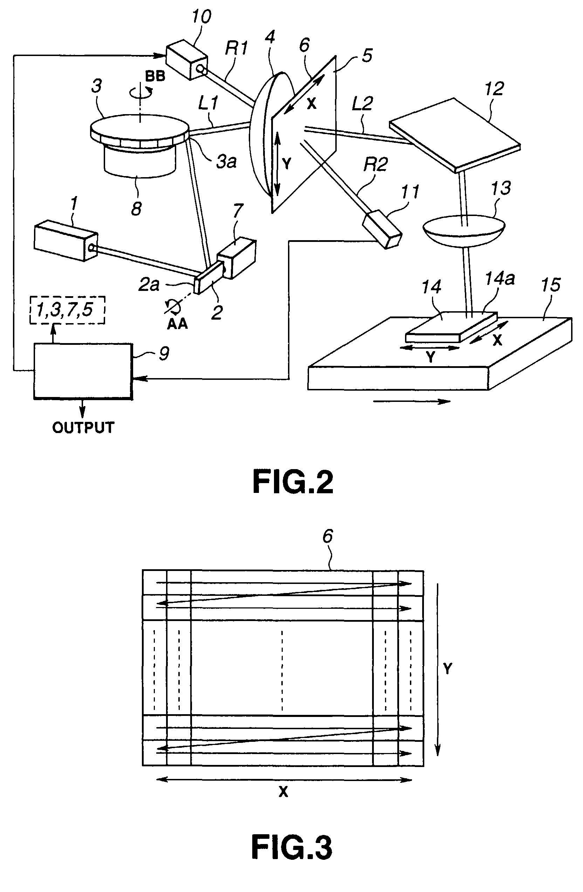

Fig.2 is an approximate composite diagram of a marking device to which a method of marking works relating to this invention is applied.

In Fig.2, l is a laser oscillator which generates laser light (for example, YAG laser light) for scanning, and the laser light generated is directed onto the reflecting surface 2a of a scanning mirror 2, which forms a Y-direction deflecting element. The laser light reflected by the reflecting mirror 2a is directed onto a reflecting surface 3a of a polygon mirror. The laser light L reflected at reflecting surface 3a is directed via a lens 4 onto a display surface 6 of a polymer composite-type liquid crystal mask 5. Here, the reflecting surface 2a of the scanning mirror 2 is rotated in the direction of arrow AA by a motor 7, and the reflecting surface 3a of the polygon mirror 3 is rotated in the direction of arrow BB by a motor 8. Specifically, when the motor 8 is driven and the reflecting surface 3a rotates in the direction of arrow BB, the laser light scans over the display surface 6 of the liquid crystal mask 5 along a principal axis, in the direction indicated by arrow X. Furthermore, when the motor 7 is driven and the reflecting surface 2a rotates in the direction of arrow AA, the laser light scans over the display surface 6 of the liquid crystal mask 5 along a secondary axis, in the direction indicated by arrow Y.

Fig.3 shows the manner in which the laser light scans over the display surface 6. As shown in Fig.3, by moving the laser light in the Y direction whilst scanning in the X direction, laser light is scanned over the entire display surface 6.

In Fig.2, sensors 10 and 11 serve to detect the transmissivity of the liquid crystal mask 5. The transmissivity is measured by directing a laser light R1 at the liquid crystal mask 5 from sensor 10 and receiving the transmitted laser light R2 at sensor 11. A controller 9 feeds back the transmissivity via sensors 10 and 11, and controls the liquid crystal drive voltage such that the liquid crystal mask 5 is maintained at a constant transmissivity.

Furthermore, the controller 9 outputs signals for writing printing patterns of a prescribed shape to the liquid crystal mask 5, and in addition, it controls the laser generation from the laser oscillator 1, and controls the scanning of the laser light in the X and Y directions over the liquid crystal mask 5. In other words, in addition to generating the printing pattern on the display surface 6 of the liquid crystal mask 5, the controller 9 also conducts scanning of the laser light L1, by driving and controlling the motors 7, 8 and the laser oscillator 1. By this means, the laser light L1 is transmitted only through the areas of the printing pattern formed in the liquid crystal mask 5. The transmitted laser light L2 is then directed via a mirror 12 and a lens 13 onto a work 14, and characters, diagrams, or the like, corresponding to the shape of the printing pattern are marked on the surface of the work 14.

The mirror 12 and lens 13 are driven by movement mechanisms (omitted from drawing) which have respectively independent motors as drive sources. These movement mechanisms serve to move, in the X and Y directions, the point at which the laser light L2 transmitted through the display surface 6 of the liquid crystal mask 5 falls onto the work 14, and they are driven and controlled by the controller 9. The controller 9 can locate a position in the X and Y directions by driving and controlling the mirror 12 and the lens 13 using these movement mechanisms. The laser light fed through the mirror 12 and lens 13 is directed onto works 14 arranged in a line on a lead frame 15 (in Fig.2, only one lead frame and one work are shown, respectively).

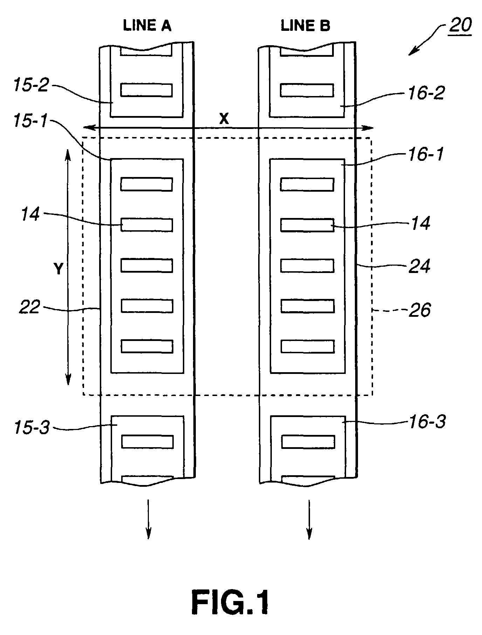

Fig.1 shows an arrangement of works when marking is carried out, viewed from the direction in which the laser light is irradiated onto the works.

A conveyer 20 consists of conveyor sections 22, 24 arranged in parallel, a drive section (omitted from drawing) which drives these conveyor sections, and a control section (omitted from drawing) which controls the operation of this drive section. A lead frame 15 (15-1 to 15-3) in line A is carried on conveyor section 22, and a lead frame 16 (16-1 to 16-3) in line B is carried on conveyor section 24. The conveyor sections are driven independently from each other, and they are controlled such that the lead frames halt in a marking area 26, as indicated by the dotted line.

The optical system comprising the mirror 12 and the lens 13 illustrated in Fig.2 moves the laser light in the X and Y directions in Fig.1, by means of the movement mechanisms (omitted from drawings). Specifically, the optical system moves in the Y direction to move the illumination point of the laser light between works, and the optical system moves in the X direction to move the illumination point of the laser light between lines.

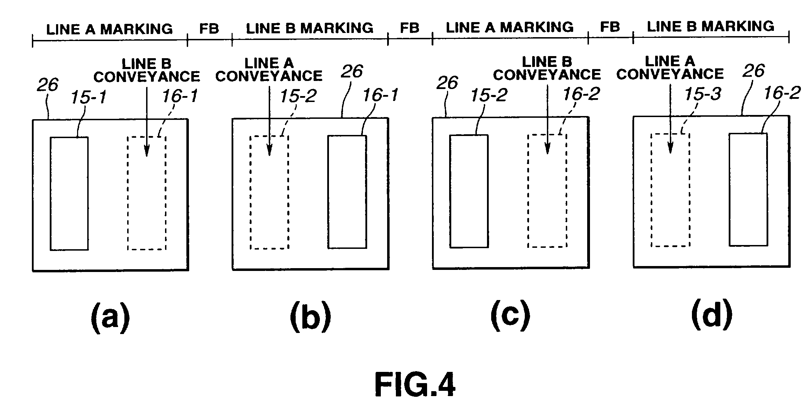

Fig.4 gives a schematic representation of a procedure when works are marked alternately; elements which are the same as in Fig.1 are indicated by the same label. Below, a procedure (a) to (d) when works are marked alternately is described with reference to Fig.4.

Fig.4 describes a case where lead frames arranged in two lines (line A and line B) are subjected to marking alternately. The feedback (FB) control of transmissivity, situated between the marking operations in Fig.4, is conducted according to requirements.
(a) A lead frame 15-1 in line A is conveyed to the marking area 26 and the works on the lead frame 15-1 are subjected to marking. During marking of line A, in line B, a lead frame 16-1 is conveyed to the marking area 26 and assumes a stand-by state.
(b) When marking of the works in line A is completed, the illumination point of the laser light moves to the line B side and the works on the lead frame 16-1 in line B are subjected to marking. During this operation, in line A, the lead frame 15-1 on which marking has been completed is moved, whilst at the same time a subsequent lead frame 15-2 is conveyed to the marking area 26 and assumes a stand-by state.
(c) When marking of the works in line B is completed, the illumination point of the laser light moves the line A side, and the works on the lead frame 15-2 in line A are subjected to marking. During this operation, in line B, the lead frame 16-1 on which marking has been completed is moved, whilst at the same time a subsequent lead frame 16-2 is conveyed to the marking area 26 and assumes a stand-by state.
(d) When marking of the works in line A is completed, the illumination point of the laser light moves to the line B side and the works on the lead frame 16-2 in line B are subjected to marking. During this operation, in line A, the lead frame 15-2 on which marking has been completed is moved, whilst at the same time a subsequent lead frame 15-3 is conveyed to the marking area 26 and assumes a stand-by state.

In this way, it is possible to conduct alternate marking of works, in lines A and B, by repeating the operations described in (a) to (d) above.

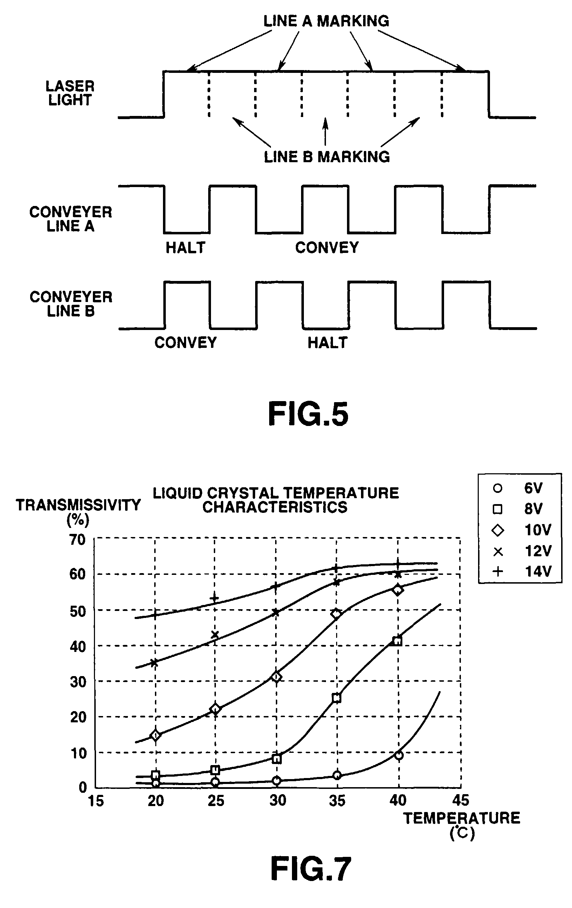

Fig.5 shows a time chart for the operations in alternate marking of works. The marking operation by means of a marking device according to this embodiment is devised such that works arranged in two lines are conveyed and halted (marked) alternately, whereby it is possible for the laser light to be output in a virtually continuous manner. Consequently, there is no interruption in the marking operation during switching (conveyance) from works to works, as occurs conventionally, and hence there is no waste in working time during conveyance of works. Thereby, high-speed marking becomes possible, and reductions in handling time can be achieved.

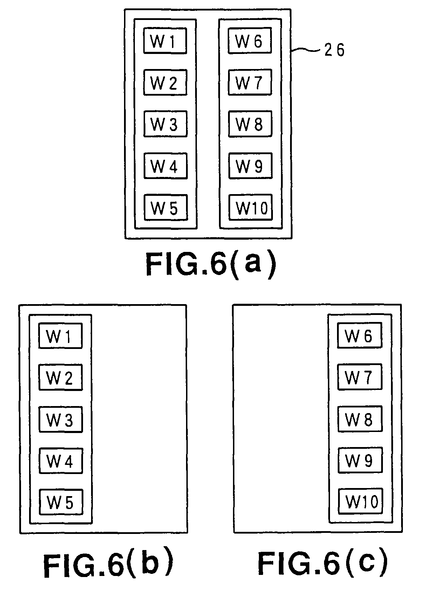

In the marking device according to this embodiment, the selection of the works line to be marked is controlled as follows, in order to conduct alternate marking of works. Fig.6(a) shows the positional relationships between works in the marking area; in the diagram, W1 to W5 and W6 to W10 represent the respective positions of works. When the conveyer (see Fig.1) conveys the lead frame 15 (16) to the marking area, a marking request signal and an input signal corresponding to the works line to be marked are output to the controller 9 (see Fig.2) of the marking device. On receiving these signals, the controller 9 initiates scanning of the laser light onto the works line for which the input signal is 'ON'. For example, when marking the works on the right-hand side of the marking area, the input signal for W1 to W5 is set to 'ON' and the other input signal is set to OFF, as depicted in Fig.6(b). Furthermore, when marking the works on the left-hand side of the marking area, the input signal for W6 to W10 is set to 'ON' and the other input signal is set to OFF, as depicted in Fig.6(c).

In the marking device according to the embodiment described above, a liquid crystal mask is used as a means of masking the laser light, but since the transmissivity of liquid crystals changes with temperature, it is necessary to stabilize the transmissivity of the liquid crystal mask in order to achieve marking of uniform quality. Therefore, in conventional marking devices, after each marking operation is completed, the transmissivity of the liquid crystal mask is fed back via sensors, and the liquid crystal drive voltage is controlled such that uniform transmissivity is maintained. However, since this control is implemented at the same timing as the alternate marking described above, it diminishes the merits of high-speed operation brought by the alternate marking method.

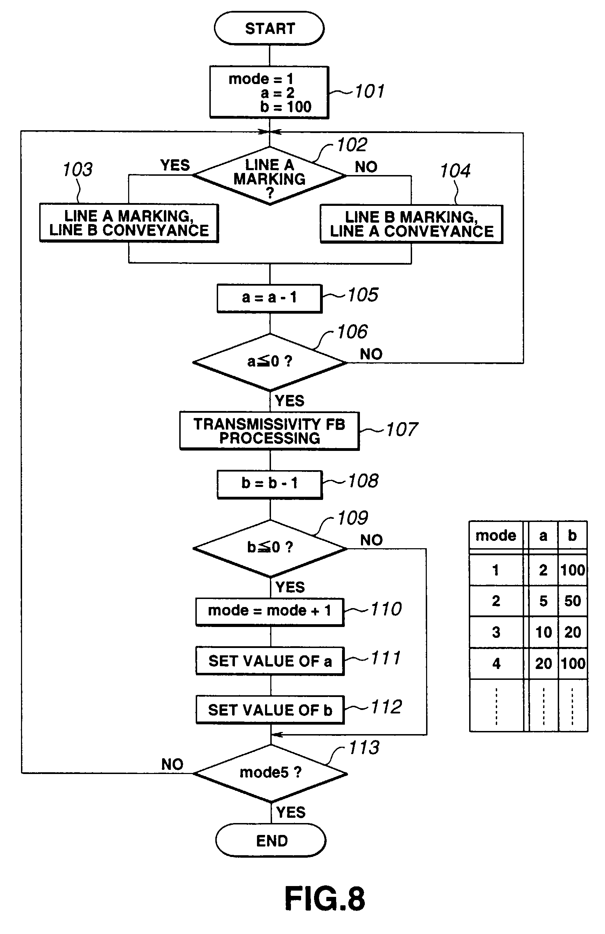

Therefore, in order to prevent reduction in marking quality when the speed of operation is increased, it is necessary to change the timing at which feedback of transmissivity is conducted, from once for every cycle, to once for every certain number of cycles. Below, cases are described where transmissivity is controlled on the basis of the number of marking cycles, and of the temperature at the perimeter of the liquid crystal mask.
(1) Controlling transmissivity according to number of marking cycles
   Fig.7 shows the relationship between temperature and transmissivity in liquid crystals, for different drive voltages. As shown in the diagram, although liquid crystal transmissivity becomes more stable as the temperature increases, at lower temperatures, it changes significantly. Accordingly, the transmissivity of the liquid crystal mask displays greatest variation immediately after the start of marking, and it stabilizes as the number of marking cycles increases. In other words, frequent control of transmissivity is required until the liquid crystals reach a high temperature. Therefore, in this method, control is implemented such that feedback is conducted intensively immediately after the start of marking, and as the number of marking cycles increases, the feedback frequency is gradually decreased.
   Next, the processing steps in the controller 9, when the transmissivity is controlled according to the number of marking cycles, are described using the flow-chart shown in Fig.8.
   The mode numbers 1, 2, 3, ... in the mode table each indicate an interval and a number of repetitions for feedback control. Here, the temperature region of the liquid crystal mask is specified according to the number of marking cycles, and the frequency is set corresponding to this temperature region. Column "a" indicates the number of marking cycles conducted until a first feedback operation is implemented, and column "b" indicates how many times the process in "a" is to be repeated. For example, mode 2 represents a mode where a feedback operation is conducted at a rate of once every five cycles and this pattern is repeated 50 times.
   In this example, initially, feedback control is implemented at the interval and number of repetitions in mode 1, and it then changes mode in order through modes 2, 3, 4, ... . However, in this example, it ends when mode 4 has been completed.
   Firstly, initial values are set as: mode = 1; a = 2; b = 100 (step 101), and it is determined whether line A is to be marked (step 102). If line A is to be marked, then marking of line A and conveyance of line B are implemented (step 103), and if line B is to be marked, then marking of line B and conveyance of line A are implemented (step 104). Thereupon, value a is decremented by 1 (step 105), and it is determined if a ≤ 0 (step 106). Here, if a > 0, in other words, if the number of marking cycles has not reached a, then the controller returns to step 102 and implements the marking process in step 103 or step 104.
   If a ≤ 0 at step 106, in other words, if the number of marking cycles has reached a, then feedback (FB) processing of the transmissivity is conducted (step 107). Thereupon, value b is decremented by 1 (step 108), and it is determined if b ≤ 0 (step 109). Here, if b > 0, in other words, if the number of repetitions of feedback processing has not reached b, the controller proceeds to step 113, where it determines whether mode 5 has been reached (step 113). If mode 5 has not been reached, the controller returns to step 102, and conducts further marking and feedback processing.
   At step 109, if b ≤ 0, in other words, if the number of repetitions of feedback processing has reached b, the mode number is incremented by 1 (step 110), and values corresponding to the new mode number are set for a and b, respectively (step 111, step 112). The processing described above is repeated until mode 5 is reached at step 113, in other words, until mode 4 is completed.
   In this embodiment, the temperature region of the liquid crystal mask is specified according to the number of marking cycles, and its transmissivity is controlled at a frequency corresponding to this temperature region. In other words, the liquid crystal mask is controlled at timings which are adapted to the temporal change in transmissivity. Therefore, by controlling transmissivity intermittently in the range where there is no effect on marking quality, it is possible to maintain the transmissivity of the mask at a virtually constant level, without diminishing the merits of continuously conveying the works, in comparison to conventional cases where transmissivity is controlled at every marking cycle.
(2) Controlling transmissivity according to the temperature at the perimeter of the liquid crystal mask
   Here, the temperature at the perimeter of the liquid crystal mask is measured by a temperature sensor, and the frequency of feedback processing is altered on the basis of measured temperature changes. Specifically, control is implemented such that when the temperature is low and the transmissivity is unstable, feedback processing is conducted intensively, and as the temperature increases and the transmissivity stabilizes, the frequency of feedback processing is decreased.

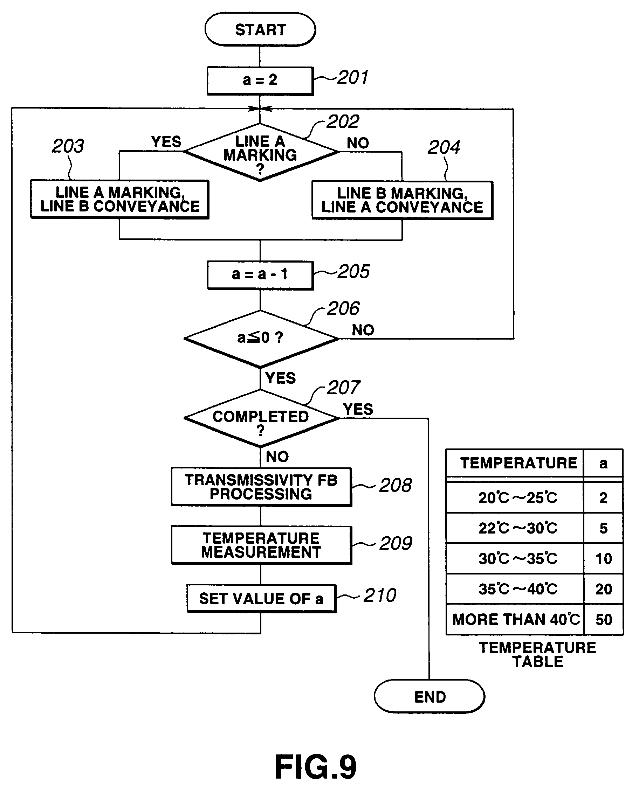

Next, the processing steps in the controller, when controlling transmissivity according to the temperature at the perimeter of the liquid crystal mask, are described using the flow-chart shown in Fig.9. Here, column 'a' in the temperature table indicates the number of marking cycles conducted until a first feedback control is implemented, in different temperature ranges. For example, it indicates that, at 25°C to 30°C, feedback control is implemented at a rate of once every 5 cycles.

Firstly, value a is set an initial value of 2 (step 201), and it is determined whether line A is to be marked (step 202). If line A is to be marked, then marking of line A and conveyance of line B are implemented (step 203), and if line B is to be marked, then marking of line B and conveyance of line A are implemented (step 204). Thereupon, value a is decremented by 1 (step 205), and it is determined if a ≤ 0 (step 206). Here, if a > 0, in other words, if the number of marking cycles has not reached a, then the controller returns to step 202, and conducts marking processing at step 203 or step 204.

If a ≤ 0 at step 206, in other words, if the number of marking cycles has reached a, then it is determined whether or not the work has been completed (step 207), and if it has not been completed, then feedback processing of the transmissivity is conducted (step 208). Thereupon, the temperature at the perimeter of the liquid crystal mask is measured by the temperature sensor (step 209), and a is set to a value corresponding to the measured temperature (step 210). Thereafter, the processing described above is repeated until the work is completed at step 207.

In this embodiment, the temperature at the perimeter of the liquid crystal mask is measured, and its transmissivity is controlled at a frequency corresponding to the temperature range thereof. In other words, the liquid crystal mask is controlled at timings which are adapted to actual temperature changes. Therefore, by controlling transmissivity intermittently in the range where there is no effect on marking quality, it is possible to maintain the transmissivity of the mask at a virtually constant level, without diminishing the merits of continuously conveying the works, in comparison to conventional cases where transmissivity is controlled at every marking cycle.

In the embodiments detailed above, an example was described wherein lead frames arranged in two lines (line A and line B) are marked alternately, but even if lead frames are arranged in three lines or more, a similar method can be applied. Furthermore, the number of works on a lead frame is not limited to any particular number, provided that the works are within the marking area. Moreover, the conveyer is not limited to the belt-shaped structure illustrated in Fig.1, provided that it is capable of conveying lead frames in order.

This invention is not limited to the embodiments described above and illustrated in the drawings, and various modifications are conceivable within the scope of the claims.

### INDUSTRIAL APPLICABILITY

As described above, the method of marking works relating to this invention is applied to marking devices for marking prescribed printing patterns on works.

## Claims

1. In a marking device which irradiates laser light onto a mask wherein a printing pattern of a prescribed shape is formed, and scans the laser light over the mask, thereby marking the printing pattern formed in the mask onto works,
a method of marking works, characterized in that the works are arranged on a plurality of parallel lines, the plurality of lines is conveyed and halted independently, and whilst works on a halted line in the marking area are being marked, works on at least one of the remaining lines are conveyed to the marking area.

2. A method of marking works according to claim 1, characterized in that the mask is a liquid crystal mask.

3. In a marking device which irradiates laser light onto a liquid crystal mask wherein a printing pattern of a prescribed shape is formed, and scans the laser light over the liquid crystal mask, thereby marking the printing pattern formed in the liquid crystal mask onto works,
a method of marking works, characterized in that the method comprises:
a first step, whereby the works are arranged on a plurality of parallel lines, the plurality of lines is conveyed and halted independently, and whilst works on a halted line in the marking area are being marked, works on at least one of the remaining lines are conveyed to the marking area; and
in parallel with the first step, a second step whereby a transmissivity of the liquid crystal mask is controlled at a frequency corresponding to the number of work marking cycles.

4. In a marking device which irradiates laser light onto a liquid crystal mask wherein a printing pattern of a prescribed shape is formed, and scans the laser light over the liquid crystal mask, thereby marking the printing pattern formed in the liquid crystal mask onto works,
a method of marking works, characterized in that the method comprises:
a first step, whereby the works are arranged on a plurality of parallel lines, the plurality of lines is conveyed and halted independently, and whilst works on a halted line in the marking area are being marked, works on at least one of the remaining lines are conveyed to the marking area; and
in parallel with the first step, a second step whereby the transmissivity of the liquid crystal mask is controlled at a frequency corresponding to a temperature measured at the perimeter of the liquid crystal mask.

## Amended claims

### Amended claims under Art. 19.1 PCT

1. (Deleted)
2. (Deleted)
3. In a marking device which irradiates laser light onto a liquid crystal mask wherein a printing pattern of a prescribed shape is formed, and scans the laser light over the liquid crystal mask, thereby marking the printing pattern formed in the liquid crystal mask onto works,
a method of marking works, characterized in that the method comprises:
a first step, whereby the works are arranged on a plurality of parallel lines, the plurality of lines is conveyed and halted independently, and whilst works on a halted line in the marking area are being marked, works on at least one of the remaining lines are conveyed to the marking area; and
in parallel with the first step, a second step whereby a transmissivity of the liquid crystal mask is controlled at a frequency corresponding to the number of work marking cycles.
4. In a marking device which irradiates laser light onto a liquid crystal mask wherein a printing pattern of a prescribed shape is formed, and scans the laser light over the liquid crystal mask, thereby marking the printing pattern formed in the liquid crystal mask onto works,
a method of marking works, characterized in that the method comprises:
a first step, whereby the works are arranged on a plurality of parallel lines, the plurality of lines is conveyed and halted independently, and whilst works on a halted line in the marking area are being marked, works on at least one of the remaining lines are conveyed to the marking area; and
in parallel with the first step, a second step whereby the transmissivity of the liquid crystal mask is controlled at a frequency corresponding to a temperature measured at the perimeter of the liquid crystal mask.
